# EUROPEAN PATENT SPECIFICATION

(11) **EP 3 789 665 B1**
(45) Date of publication and mention of the grant of the patent: **24.04.2024**
(21) Application number: 18917437.8
(22) Date of filing: 05.11.2018
(51) Int. Cl.: F21V 8/00, F21W 102/135, B60Q 1/04, F21S 41/255, F21S 41/14, H01L 25/075, H01L 33/20, F21S 41/153, F21S 41/663, F21S 41/143, F21W 102/155, F21W 102/13, F21Y 107/50, F21W 102/19, F21S 41/19, F21S 41/25, H01L 33/58

(54) **HEADLIGHT**
SCHEINWERFER
PHARE

(30) Priority: 03.05.2018 CN 201810414967
(43) Date of publication of application: 10.03.2021
(73) Proprietor: YLX Incorporated, Shenzhen, Guangdong 518057 (CN)
(72) Inventor: HU, Fei, Shenzhen, Guangdong 518000 (CN); XU, Mengmeng, Shenzhen, Guangdong 518000 (CN)
(74) Representative: Zaboliene, Reda
(86) International application number: PCT/CN2018/113873
(87) International publication number: WO 2019/210668

(56) References cited:
- EP-A1- 2 826 667
- EP-A2- 2 306 075
- EP-A2- 2 620 694
- EP-A2- 2 778 511
- WO-A1-2014/032071
- CN-A- 1 526 985
- CN-A- 1 591 921
- CN-A- 101 457 889
- CN-A- 105 351 839
- CN-A- 107 735 615
- CN-A- 108 302 485
- FR-A1- 3 039 880
- FR-A1- 3 053 758
- JP-A- 2011 249 183
- JP-A- 2013 084 452
- JP-A- 2013 168 434
- US-A1- 2015 009 698
- US-A1- 2015 043 239

## Description

### TECHNICAL FIELD

The present invention relates to the technical field of lighting, specifically to a headlight and a lighting emitting device thereof.

### BACKGROUND

Vehicle headlights are an important factor affecting vehicle driving safety. The development of the vehicle industry has given rise to higher and higher requirements for vehicle headlights. For a vehicle headlight, safety lighting is its main purpose. In urban traffic, in order to prevent the headlights from dazzling the driver of oncoming car during meeting cars, strict requirements on meeting lights (namely the low beam lights) are proposed in countries all over the world. It is required that the light emitted by the low beam lights must form a clear low beam cut-off line.

By a long-term research and development, the inventor(s) of the present invention have discovered that in related arts, shading technology is usually used to achieve the clear low beam cut-off line. However, a low utilization rate of light emitted by the light source is an inevitable defect of shading technology.

JP2013168434A relates to a light-emitting module 24 used for a lamp tool. The light-emitting module 24 includes a light source in which a plurality of LEDs 34 is arranged as LED arrays 26a, 26b at a plurality of steps; and a loading part which loads the light source. The loading part has a first loading part 30a1 which loads the LED array 26a of the light source; and a second loading part 30b1 which loads the LED array 26b adjacent to the LED array 26a, and is provided at a position shifted in the rear part rather than the first loading part 30a1 when the light source is viewed from the front surface.

EP 2826667 A1 relates to a technique capable of achieving AFS control without using mechanical means. A vehicle headlamp (20R, 20L) for forming a low beam that illuminates a relatively lower region of a space in front of a vehicle, including a first light source apparatus (25) for forming a first irradiating light (100), a second light source apparatus (24) for forming a second irradiating light (101) with a width in the up-down direction that is smaller than that of the first irradiating light (100) on an upper end side of the first irradiating light (100), and a lens (23) that projects the light emitted from the first light source apparatus (25) and the second light source apparatus (24), respectively, wherein the second light source apparatus (24) includes a first light-emitting device array that extends in a first direction, and the first light-emitting device array includes a plurality of light-emitting devices capable of being individually turned on and off, arranged along the first direction.

WO 2014/032071 A1 relates to a lighting unit for a headlight, more particularly a motor vehicle headlight, consisting of a plurality of light sources (1), a light guide unit (2) having a plurality of light guides (3) and a downstream projection lens having a focal plane (E), wherein each light guide (3) respectively has a light coupling-out surface (4), wherein a.) the light coupling-out surfaces (4) of at least two adjacent light guides (3) are offset with respect to one another in relation to the focal plane (E), and/or b.)at least two mutually adjacent light guides (3) in each case make contact with one another along an extent (b und b') in a contact region (12), wherein the respective extents (b und b') deviate from one another, measured in relation to the focal plane (E).

US 2015/043239 A1 relates to a lamp for a vehicle. The lamp includes: an LED array; and an aspherical lens disposed in front of the LED array, in which a first stepped portion is provided on a light incident surface of the aspherical lens, and a second stepped portion is provided on a light exit surface of the aspherical lens, thereby reducing a brightness difference between a central portion and both side portions of a lighting image, and preventing light blurring.

EP2306075A2 relates to a headlight. The headlight has a light module comprising a matrix-like arrangement of semiconductor sources i.e., LEDS, a primary lens (3) and a secondary lens. Light emission regions (36, 38, 40) comprising light emission surfaces, which differentiate middle rows (34) in the form of light emission surfaces of adjacent rows (44, 46). A middle light emission region of the middle rows is separated from the adjacent light emission regions of the middle rows by two V-shaped edges during reflection by the secondary lens. The edges are tapered together.

FR 3039880 A1 relates to a light device for a motor vehicle. The light device comprises a semiconductor light source (1) and projection optics adapted to image the light source outside the vehicle. The light source comprises a plurality of light-emitting rods (8) of sub-millimeter dimensions, in which the density and/or the height of the rods are adapted so that the light source has at least a first zone (ZR') and a second zone (ZC') defined by a plurality of rods and having different luminance from one zone to another.

### SUMMARY

A main technical problem to be solved by the present invention is to provide a headlight, which can improve its light utilization rate while ensuring definition of its low beam cut-off line.

In order to solve the technical problem, a technical solution adopted in the present invention is to provide a headlight as defined in claim 1.

In one embodiment, a size of each of the plurality of first light-emitting units is less than a size of each of the plurality of second light-emitting units. This technical solution enables a light spot formed by the first light-emitting unit in the distribution of outgoing light to have a small "pixel", so that the cut-off line formed by the first light-emitting units has a higher definition.

In one embodiment, the light-emitting device further includes a substrate. A side of the substrate close to the lens has a first plane and a second plane. The first light-emitting units are arranged on the first plane, the second light-emitting units are arranged on the second plane, and a distance from the first plane to the front focal plane is less than a distance from the second plane to the front focal plane.

In one embodiment, the first plane overlaps the front focal plane.

In one embodiment, the second plane is between the first plane and the lens.

In one embodiment, the first plane is between the second plane and the lens.

In one embodiment, some, or all of the first light-emitting units and the second light-emitting units have a light-emitting surface covered by a scattering layer.

Wherein the light-emitting device further includes a substrate, a side of the substrate close to the lens has a curved surface, the first light-emitting units and the second light-emitting units are arranged on the curved surface. The structure of the curved surface makes illuminance transition of each irradiated area of the emitted light more uniform, avoiding too strong light and dark changes in the irradiated areas.

In one embodiment, the plurality of first light-emitting units and the plurality of second light-emitting units are sequentially arranged in a light-emitting area, the light-emitting area includes a first area and a second area located on a side of the low beam cut-off line, the second area is close to the low beam cut-off line, an area of the second area close to the low beam cut-off line is provided with the first light-emitting units, the first area and other areas of the second area are provided with the second light-emitting units; the headlight further includes a controller, the controller is electrically to the first light-emitting units and the second light-emitting units, the controller controls the first light-emitting units and the second light-emitting units to emit light, so as to realize a low beam distribution of the headlight.

In one embodiment, the light-emitting area further includes a third area, the third area is on another side of the low beam cut-off line; the light-emitting device further includes a third light-emitting module, the third light-emitting module includes a plurality of third light-emitting units, an area of the third area close to the low beam cut-off line is provided with the first light-emitting units, and other areas of the third area are provided with the third light-emitting units; the controller is electrically connected to the third light-emitting units, and the controller controls the first light-emitting units, the second light-emitting units, and the third light-emitting units to emit light, so as to realize a high beam distribution of the headlight.

In one embodiment, a distance from the first light-emitting units provided corresponding to the first area to the front focal plane and a distance from the first light-emitting units provided corresponding to the third area to the front focal plane are different. When the front light is in a high-beam mode, the clear cut-off line of the original low beam irradiation area will make an obvious light and dark boundary in a high-beam irradiation area. In this embodiment, the first light-emitting elements in the first area and the third area close to the low beam cut-off line are set at different positions, so that distances to the front focal plane are different. As a result, part of the emitted light of the first light-emitting elements is collected by the lens and has a large divergence angle, forming a large spot in the illumination area, thereby weakening the bright and dark boundary in the high beam illumination area.

The beneficial effect of the embodiments of the present invention is as follows. Different from the prior arts, the headlight of the embodiments of the present invention includes a light-emitting device, the light-emitting device includes: a first light-emitting module including a plurality of first light-emitting units, wherein an arrangement of the first light-emitting units is consistent with a low beam cut-off line of the headlight; a second light-emitting module including a plurality of second light-emitting units; and a lens configured to project a light of the first light-emitting units and/or the second light-emitting units, wherein a distance between the first light-emitting units and a front focal plane of the lens is less than a distance between the second light-emitting units and the front focal plane. In this way, the distance between the plurality of first light-emitting units provided corresponding to the low beam cut-off line and the front focal plane of the lens of the headlight of the present invention is less than the distance of other light-emitting units (i.e., the second light-emitting units) with the front focal plane. On one hand, the projection divergence angle of the light emitted by the first light-emitting units by the lens can be reduced, so as to improve the definition of the low beam cut-off line. On the other hand, the projection divergence angle of the light emitted by the second light-emitting units by the lens can be enlarged, so as to improve uniformity of light in other illumination areas of the headlight and reduce the light and dark stripes generated from gaps between the first light emitting units. Also, the present invention can achieve a clear low beam cut-off line without a shading plate, and thus the light utilization can be improved.

### BRIEF DESCRIPTION OF THE DRAWINGS

FIG. 1 is a schematic diagram of a structure of a headlight according to an embodiment of the present invention.
FIG. 2 is a schematic diagram of a structure of a light-emitting device in the headlight according to the embodiment of FIG. 1.
FIG. 3 is a test diagram of a light distribution screen of the light-emitting device according to the embodiment of FIG. 2.
FIG. 4 is a schematic diagram of a light path of the headlight of the present invention.
FIG. 5 is a schematic diagram of a structure of the headlight according to a second embodiment of the present invention.
FIG. 6 is a schematic diagram of a structure of the light-emitting device in the headlight according to the embodiment of FIG. 5.
FIG. 7 is a schematic diagram of a structure of the light-emitting device according to a third embodiment of the present invention.
FIG. 8 is a schematic diagram of a structure of the headlight according to a third embodiment of the present invention.
FIG. 9 is a schematic diagram of a structure of the headlight according to a fourth embodiment of the present invention.
FIG. 10 is a schematic diagram of a structure of the headlight according to a fifth embodiment of the present invention.

### DETAILED DESCRIPTION

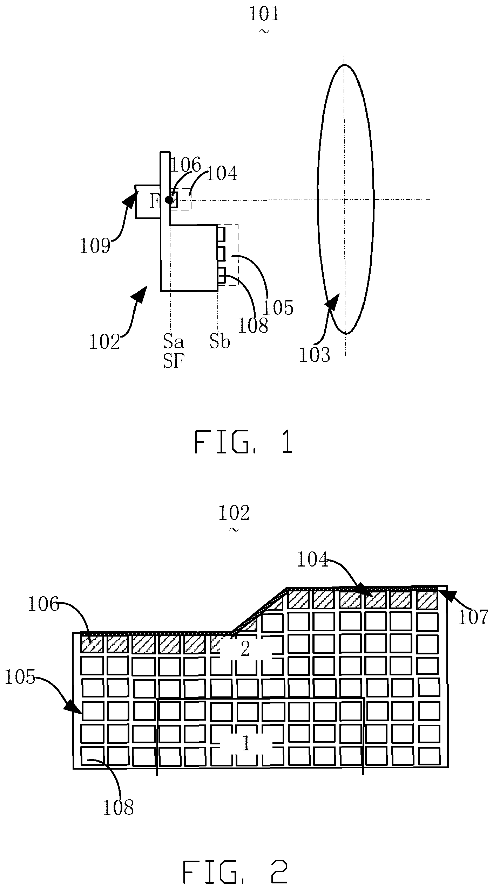

Please refer to FIGS. 1 and 2. FIG. 1 is a schematic diagram of a structure of a headlight according to an embodiment of the present invention. FIG. 2 is a schematic diagram of a structure of a light-emitting device in the headlight of FIG. 1. In this embodiment, the headlight 101 includes a light-emitting device 102 and a lens 103. The light-emitting device 102 includes a first light-emitting module 104 and a second light-emitting module 105. The first light-emitting module 104 includes a plurality of first light-emitting units 106. An arrangement of the plurality of first light-emitting units 106 is consistent with a low beam cut-off line 107 of the headlight 101. The second light-emitting module 105 includes a plurality of second light-emitting units 108. The lens 103 is configured to project a light of the first light-emitting units 106 and/or the second light-emitting units 108. A distance between the first light-emitting units 106 and a front focal plane SF of the lens 103 is less than a distance between the second light-emitting units 108 and the front focal plane SF. The front focal plane is a plane passing through a first focal point (that is, a front focal point or an object focal point) and perpendicular to a main optical axis of the system, also known as a first focal plane or an object focal plane.

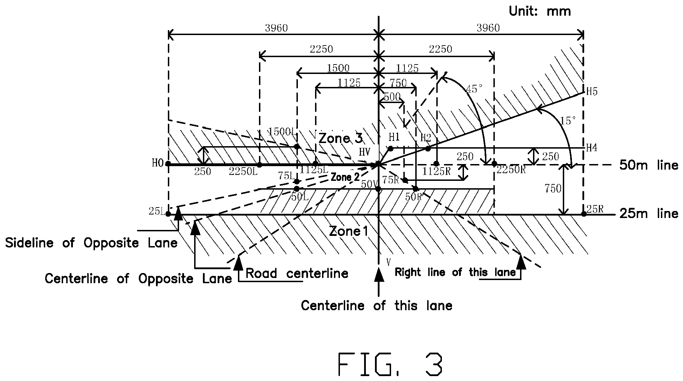

In this embodiment, the arrangement of the plurality of first light-emitting units 106 is consistent with the low beam cut-off line 107 of the headlight 101, which means that the plurality of first light-emitting units 106 are arranged along the low beam cut-off line 107. The low beam cut-off line 107 described herein corresponds to the low beam cut-off line H0-HV-H1-H4 in a light distribution screen test diagram (as shown in FIG. 3).

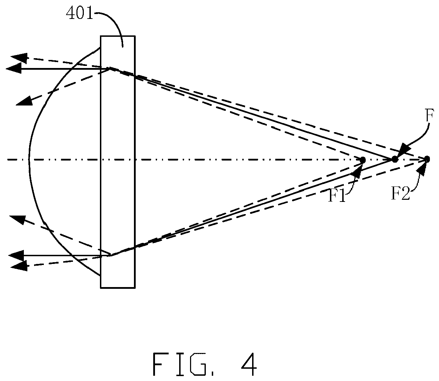

As shown in FIG. 4, FIG. 4 is a schematic diagram of a light path of the headlight of the present invention. When the light-emitting units (not shown in the figures) is at the focal point F or the plane of the focal point F of the lens 401, that is, the front focal plane (not shown in the figures), a divergence angle of the projection of the light emitted by the light-emitting units by the lens 401 is relatively small, and the image of the projection is relatively clear. When the light-emitting units deviate from the focus F or the front focal plane, such as points F1, F2, and so on, the projection divergence angle of the light emitted by the light-emitting units by the lens 401 is relatively large, and the image is relatively blurred. The greater the distance the light-emitting units deviate from the focal point F or the front focal plane, the greater the divergence angle and the blurry the image.

According to the above principle, in this embodiment, the distance between the plurality of first light-emitting units 106 aligned with the low beam cut-off line 107 and the front focal plane SF of the lens 103 is less than the distance between other light-emitting units (i.e., the second light-emitting units 108) and the front focal plane SF of the lens 103. On one hand, the projection divergence angle of the light emitted by the first light-emitting units 106 by the lens 103 can be reduced, so as to improve the definition of the low beam cut-off line H0-HV-H1-H4. On the other hand, the divergence angle of the projection of the light emitted by the second light-emitting units 108 by the lens 103 can be enlarged, so as to improve uniformity of light in other illumination areas of the headlight 101 and reduce light and dark stripes generated from gaps between the first light emitting units 106.

The first light-emitting units 106 and the second light-emitting units 108 of this embodiment may be light-emitting diodes (LEDs). Compared with traditional light sources, LEDs have advantages of energy-saving, environmental protection, long service life, small size, light weight, firm structure and low working voltage. Of course, in other embodiments, other light sources such as incandescent lamps may be used instead of LEDs.

In prior arts, there are three types of headlight structures that use LEDs as light sources:
(1) Multi-lens group type. One condenser and one LED form a lens group for projecting a beam of light to irradiate one spot on a screen. According to high beam or low beam standard requirements, the light spots generated by a plurality of lens groups are spliced into a light band to meet the illumination distribution requirements. This structure is large in volume, high in cost, and difficult to process.
(2) Free-surface lens type. The headlight is composed of one condenser and one LED, but a refracting surface of the condenser is no longer a rotating curved surface, but a free-form surface, so that the beam is projected to produce a spot that meets the requirements of the illuminance standard.
(3) Mirror-lens type. The light emitted by the LED is shaped by the free-form mirror and enters the lens for further shaping and then exits to obtain a specific light distribution.

However, the above three structures all need to use a light barrier to block part of the light to achieve the low beam cut-off line, which will cause a large amount of light loss, making a light utilization rate of the low beam only about 30%, and the light utilization rate of the entire system is low. In addition, a size of the reflector or lens is large, and the design is complicated. Additionally, existing vehicle headlights are mostly designed to include separate modules for the high beam and the low beam, which is not conducive to miniaturization of the light source.

From the above analysis, it can be seen that since the headlight 101 of this embodiment can achieve a clear low beam cut-off line H0-HV-H1-H4 without a light barrier, the light utilization efficiency can be improved.

Optionally, as shown in FIG. 3, the illumination area (not shown in the figure) that the headlight 101 emits toward the front of the vehicle includes a zone 1 and a zone 2 on a side of the low beam cut-off line H0-HV-H1-H4 close to the headlight 101. The zone 2 is adjacent to the light cut-off line H0-HV-H1-H4. As shown in FIG. 2, the plurality of first light-emitting units 106 and the plurality of second light-emitting units 108 of this embodiment are sequentially arranged in a light-emitting area (not shown). The light-emitting area includes a first area 1 and a second area 2 on one side of the low beam cut-off line 107. The second area 2 is close to the low beam cut-off line 107. The first light-emitting units 106 are provided in an area of the second area 2 close to the low beam cut-off line 107, and the second light-emitting units 108 are provided in the first area 1 and other areas of the second area 2. The first area 1 of the light-emitting area is arranged corresponding to the zone 1 of the illumination area, and the second area 2 of the light-emitting area is arranged corresponding to the zone 2 of the illumination area.

Optionally, as shown in FIG. 1, the headlight 101 of this embodiment further includes a controller 109. The controller 109 is electrically connected to the first light-emitting units 106 and the second light-emitting units 108. The controller 109 is configured to control the first light-emitting units 106 and the second light-emitting units 108 to emit light, so as to realize a low beam distribution of the headlight 101, that is, to realize the light distribution of the zone 1 and the zone 2 of the illumination area as shown in FIG. 3.

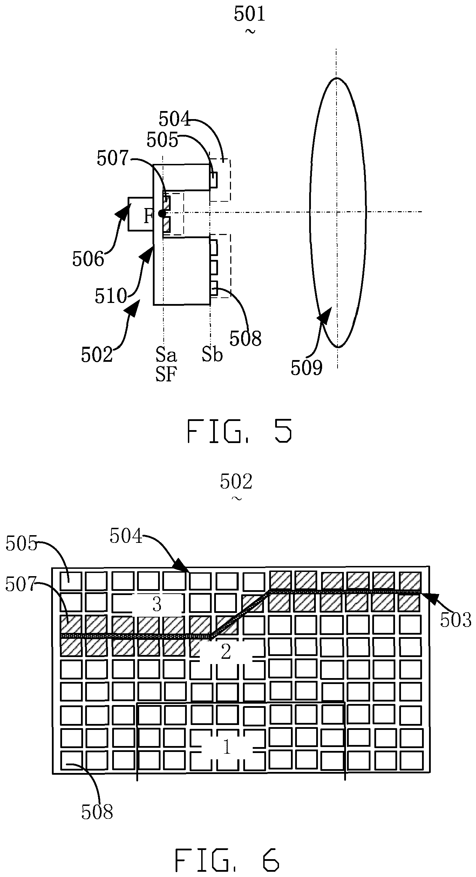

The above embodiment realizes the low beam distribution of the headlight. In order to realize a high beam distribution of the headlight, in another embodiment, as shown in FIGS. 5 and 6, the light-emitting area (not labeled) of the light-emitting device 502 in the headlight 501 of this embodiment further includes a third area 3 on the basis of the above-mentioned embodiment. The third area 3 is on the other side of the low beam cut-off line 503. The light-emitting device 502 further includes a third light-emitting module 504. The third light-emitting module 504 includes a plurality of third light-emitting units 505. The first light-emitting units 506 are provided in an area of the third area 3 close to the low beam cut-off line 503, and the third light-emitting units 505 are provided in other areas of the third area 3. The controller 506 of this embodiment is electrically connected to the third light-emitting units 505, and the controller 506 is configured to control the first light-emitting units 507, the second light-emitting units 508, and the third light-emitting units 505 to emit light, so as to realize the high beam distribution of the headlight 501, that is, to realize the light distribution of zone 1, zone 2 and zone 3 as shown in FIG. 3.

This embodiment can also realize integration of the low beam distribution and the high beam distribution of the headlight. Specifically, when the controller 506 is configured to control the first light-emitting units 506 and the second light-emitting units 507 in the first area 1 and the second area 2 to emit light, the low beam distribution of the headlight 501 can be realized. When the controller 506 is configured to control the first light-emitting units 507, the second light-emitting units 508 and the third light-emitting units 505 to emit light, the high beam distribution of the headlight 501 can be realized.

As shown in FIG. 6, the low beam cut-off line 503 includes a first parallel line, an oblique line, and a second parallel line. Two ends of the oblique line are respectively connected to the first parallel line and the second parallel line. The arrangement of the plurality of first light-emitting units 507 is consistent with the first parallel line, the oblique line, and the second parallel line.

The first light-emitting units 507 on both sides of the oblique line of the low beam cutoff line 503 are right-angled triangle light-emitting units.

The controller 506 can also individually control the light emission and light emission brightness of one or more of the first light-emitting units 507, the second light-emitting units 508, and/or the third light-emitting units 505, so that the light-emitting area exhibits different light distribution patterns. The light patterns are projected onto a road through the lens 509, and the required light distribution can be obtained.

The headlight 501 of this embodiment can meet the illuminance standard of each test point in the high and low beam distribution of the test screen and the test area as shown in FIG. 3. In addition, due to a phenomenon of field curvature, the second light-emitting units 508 and the third light-emitting units 505 that are far away from the optical axis of the lens 509 become blurred after projection, and the beam divergence angle is relatively large, which can be used for curved road illumination.

Black dots in FIG. 3 indicate test points. The distribution of test points, test principles and brightness requirements are based on the prior arts, which can be carried out according to the standard requirements of vehicle headlights such as standard requirements of low beam, high beam or the like, and will be omitted here.

In this embodiment, the size and arrangement spacing of the first light-emitting units 507, the second light-emitting units 508, and the third light-emitting units 505 can be adjusted to adjust the uniformity of the illumination of the headlight 501 and a resolution of each area.

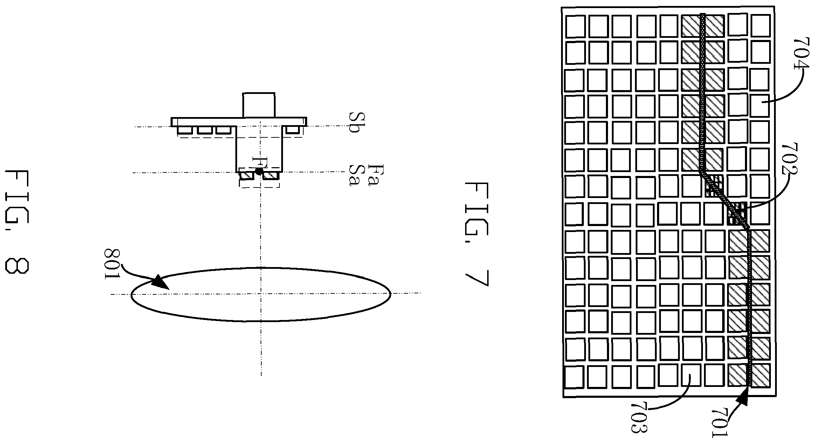

Optionally, as shown in FIG. 7, in order to improve the optical resolution at the oblique line of the low beam cut-off line 701, the size of each of the first light-emitting units 702 on both sides of the oblique line is less than the size of one of the second light-emitting units 703 or one of the third light-emitting units 704. The size (light-emitting area) of each the first light-emitting unit 702 can be 1*1 mm², 0.5*0.5 mm², and so on. The size (light-emitting area) of each second light-emitting unit 703 and each third light-emitting unit 704 can be 3 *3 mm², 8*28 mm², and so on. In this way, the light spot formed by each first light-emitting unit 702 in the emitted light distribution has a small "pixel", so that the cut-off line formed by the first light-emitting units 702 has a high definition. Of course, in other embodiments, the first light-emitting units on both sides of the first parallel line of the low beam cut-off line 701 or the first light-emitting units on both sides of the second parallel line may be further configured accordingly.

In other embodiments, small-sized light-emitting units can be used for other areas with high resolution requirements, and large-sized light-emitting units can be used in areas with higher light uniformity. The size of each of the plurality of first light-emitting units may be different, and the closer each of the first light-emitting units is to the low-beam cut-off line, the smaller its size.

In order to improve the uniformity of light distribution, some, or all of the light-emitting surface of each light-emitting unit may be covered with a scattering layer/scattering sheet (not shown). The technical solution can further improve the light uniformity and weaken the dark lines generated in a gap between two adjacent light-emitting units.

The oblique line of the low beam cut-off line in the above embodiment is 45 degrees with the first parallel line and the second parallel line, which is one of the requirements of the low beam standard for vehicle headlights. In another low beam standard requirement, the angle is 15 degrees, and the technical solutions of the embodiments of the present invention can also be adopted, which will be omitted here.

Optionally, as shown in FIG. 5, the light-emitting device 502 of this embodiment further includes a substrate 510. A first plane Sa and a second plane Sb are provided in a side of the substrate 510 close to the lens 509. The first light-emitting units 106 are arranged on the first plane Sa, the second light-emitting units 108 is arranged on the second plane Sb. A distance from the first plane Sa to the front focal plane SF is less than a distance from the second plane Sb to the front focal plane SF.

In this embodiment, a distance between each first light-emitting unit 507 and the front focal plane SF of the lens 509 is less than a distance between each second light-emitting unit 508 and each third light-emitting unit 505 and the front focal plane SF. The first light-emitting units 507 on both sides of the low beam cutoff line 503 of the headlight 501 are at the same distance from the front focal plane SF.

Of course, in other embodiments, the distance from each first light-emitting unit provided in the first area 1 to the front focal plane and the distance from each first light-emitting unit provided in the third area 3 to the front focal plane may be different. When the headlight is in a high beam mode, the clear cut-off line of the original low beam irradiation area will result in a clear boundary between light and dark in the high beam irradiation area. In this embodiment, the first light-emitting elements in the first area and the third area close to the low-beam cut-off line are set to different positions, so that the distances to the front focal plane are different. As a result, part of the emitted light of the first light-emitting elements is collected by the lens and has a large divergence angle, forming a large spot in the illumination area, thereby weakening the bright and dark boundary in the high beam illumination area.

Optionally, the first plane Sa in this embodiment and the front focal plane SF overlap. Of course, in other embodiments, the first plane Sa and the front focal plane SF may be appropriately offset.

Optionally, the second plane Sb of this embodiment is between the first plane Sa and the lens 509.

In other embodiments, as shown in FIG. 8, the first plane Sa is between the second plane Sb and the lens 801.

In order to reduce deviation between the first light-emitting units and the focal point F of the lens and improve the definition of the low beam cut-off line, center of the first light-emitting module should overlap with the focal point F of the lens.

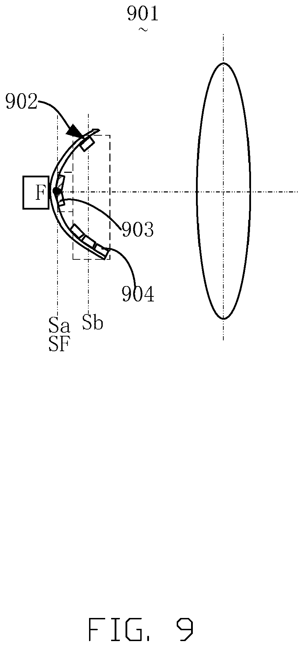

In the above-mentioned embodiment, the substrate is arranged in a square waveform to realize the first plane Sa and the second plane Sb. Of course, in other embodiments, as shown in FIG. 9, a curved surface (not shown in the figure) is provided in the side of the substrate 901 close to the lens 902, and the first light-emitting units 903 and the second light-emitting units 904 can be arranged at different positions on the curved surface. The structure of the curved surface makes the illuminance transition of each irradiated area of the emitted light more uniform, avoiding too strong light and dark changes in the irradiated area. Of course, positions of the third light-emitting units (not labeled) and the first light-emitting units 903 are also different.

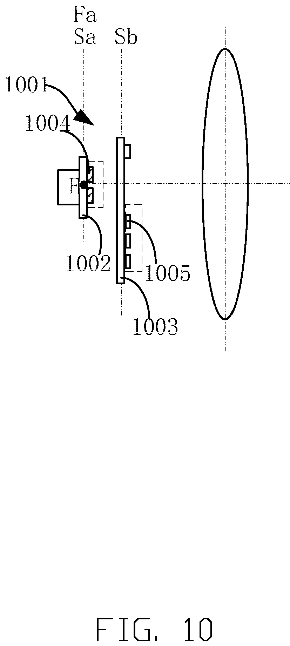

Of course, in another embodiment, as shown in FIG. 10, the light-emitting device 1001 includes a first substrate 1002 and a second substrate 1003. The first substrate 1002 is on the first plane Sa, the second substrate 1003 is on the second plane Sb. Light-emitting units 1004 are on the first substrate 1002, and the second light-emitting units 1005 are on the second substrate 1003.

Of course, the third light-emitting units and the second light-emitting units of the above embodiments may be arranged on the same plane.

In other embodiments, the oblique line or the parallel line of the low beam cut-off line of the headlight is provided with the first light-emitting units, and the above-mentioned corresponding settings are performed.

Different from the prior arts, the distance between the plurality of first light-emitting units provided corresponding to the low beam cut-off line and the front focal plane of the lens of the headlight of the present invention is less than the distance of other light-emitting units (i.e., the second light-emitting units) with the front focal plane. On one hand, the projection divergence angle of the light emitted by the first light-emitting units by the lens can be reduced, so as to improve the definition of the low beam cut-off line. On the other hand, the divergence angle of the projection of the light emitted by the second light-emitting units by the lens can be enlarged, so as to improve uniformity of light in other illumination areas of the headlight and reduce the light and dark stripes generated from gaps between the first light emitting units. Also, the present invention can achieve a clear low beam cut-off line without a shading plate. Therefore, the light utilization can be improved.

In addition, the headlight of the embodiment of the present invention can not only realize the integrated arrangement of the low beam and the high beam, but also can realize the adaptive adjustment of the light distribution of the headlight, and can realize a specific light distribution to obtain a characteristic light distribution pattern.

## Claims

1. A headlight (101, 501), comprising:
a light-emitting device (102, 502) comprising:
a lens (103, 401, 509, 801), a first light-emitting module (104) comprising a plurality of first light-emitting units (106, 507, 702, 903); and
a second light-emitting module (105) comprising a plurality of second light-emitting units (108, 508, 703, 904, 1005);
wherein the lens (103, 401, 509, 801) is configured to project light of the first light-emitting units (106, 507, 702, 903) and the second light-emitting units (108, 508, 703, 904, 1005),
wherein the first light-emitting module (104) is arranged to project a light distribution having a low-beam cut-off line (H0-HV-H1-H4),
**characterized in that** the plurality of first light-emitting units (106, 507, 702, 903) is arranged along a low beam cut-off line (107, 503) corresponding to the low beam cut-off line (H0-HV-H1-H4) of the headlight (101, 501), the low beam cut-off line (107, 503) comprises a first parallel line, an oblique line, and a second parallel line, two ends of the oblique line are respectively connected to the first parallel line and the second parallel line, the plurality of first light-emitting units (106, 507, 702, 903) is arranged along the first parallel line, the oblique line, and the second parallel line, and a distance between each of the first light-emitting units (106, 507, 702, 903) and a front focal plane (SF) of the lens (103, 401, 509, 801) is less than a distance between any of the second light-emitting units (108, 508, 703, 904, 1005) and the front focal plane (SF) of the lens (103, 401, 509, 801).

2. The headlight according to claim 1, wherein a size of each of the plurality of first light-emitting units (702) is less than a size of each of the plurality of second light-emitting units (703).

3. The headlight (501) according to claim 1, wherein the light-emitting device (502) further comprises a substrate (510), a first plane (Sa) and a second plane (Sb) are in a side of the substrate (510) close to the lens (509), the plurality of first light emitting units (507) are arranged on the first plane (Sa); the plurality of second light-emitting units (508) are arranged on the second plane (Sb), and a distance from the first plane (Sa) to the front focal plane (SF) is less than a distance from the second plane (Sb) to the front focal plane (SF).

4. The headlight (501) according to claim 3, wherein the first plane (Sa) and the front focal plane (SF) overlap.

5. The headlight (501) according to claim 3 or 4, wherein the second plane (Sb) is between the first plane (Sa) and the lens (509), or the first plane (Sa) is between the second plane (Sb) and the lens (801).

6. The headlight (501) according to claim 1, wherein some of, or all of the plurality of first light-emitting units (507) and the plurality of second light-emitting units (508) have a light-emitting surface covered by a scattering layer.

7. The headlight (501) according to claim 1, wherein the light-emitting device (502) further comprises a substrate (510), a curved surface is in a side of the substrate (510) close to the lens (509), and the plurality of first light-emitting units (507) and the plurality of second light-emitting units (508) are arranged on the curved surface.

8. The headlight (101) according to claim 1, wherein
the light-emitting device (102) further comprises a light-emitting area, the plurality of first light-emitting units (106) and the plurality of second light-emitting units (108) are arranged in the light-emitting area, the light-emitting area comprises a first area (1) and a second area (2) on one side of the low beam cut-off line (107), the second area (2) is adjacent to the low beam cut-off line (107), the plurality of first light-emitting units (106) are provided in an area of the second area (2) close to the low beam cut-off line (107), the plurality of second light-emitting units (108) are provided in the first area (1) and other areas of the second area (2); and
the headlight (101) further comprises a controller (109) electrically connected to the plurality of first light-emitting units (106) and the plurality of second light-emitting units (108), wherein the controller (109) is configured to control the plurality of first light-emitting units (106) and the plurality of second light-emitting units (108) to emit light, so as to realize a low beam distribution of the headlight.

9. The headlight (501) according to claim 8, wherein
the light-emitting area further comprises a third area (3) that is on the other side of the low beam cut-off line (503);
the light-emitting device (502) further comprises a third light-emitting module (504) comprising a plurality of third light-emitting units (505), wherein the plurality of first light-emitting units (507) are provided in an area of the third area (3) close to the low beam cut-off line (503), and the plurality of third light-emitting units (505) are provided in other areas of the third area (3); and
the controller (506) is electrically connected to the third light-emitting units (505), and configured to control the first light-emitting units (507), the second light-emitting units (508), and the third light-emitting units (505) to emit light, so as to realize a high beam distribution of the headlight (501).

10. The headlight (501) according to claim 9, wherein a distance from a part of the first light-emitting units (507) provided corresponding to the first area (1) to the front focal plane (SF) is different from a distance from another part of the first light-emitting units (507) provided corresponding to the third area (3) to the front focal plane (SF).

## Patentansprüche

1. Ein Scheinwerfer (101, 501), umfassend:
eine lichtemittierende Vorrichtung (102, 502), umfassend:
eine Linse (103, 401, 509, 801), ein erstes lichtemittierendes Modul (104), das mehrere erste lichtemittierende Einheiten (106, 507, 702, 903) umfasst; und
ein zweites lichtemittierendes Modul (105), das mehrere zweite lichtemittierende Einheiten (108, 508, 703, 904, 1005) umfasst;
wobei die Linse (103, 401, 509, 801) so konfiguriert ist, dass sie Licht der ersten lichtemittierenden Einheiten (106, 507, 702, 903) und der zweiten lichtemittierenden Einheiten (108, 508, 703, 904, 1005) projiziert),
wobei das erste lichtemittierende Modul (104) so angeordnet ist, dass es eine Lichtverteilung mit einer Abblendlicht-Grenzlinie (H0-HV-H1-H4) projiziert,
**dadurch gekennzeichnet, dass** die mehreren ersten lichtemittierenden Einheiten (106, 507, 702, 903) entlang einer Abblendlicht-Grenze (107, 503) angeordnet sind, die der Abblendlicht-Grenze (H0-HV-H1) entspricht -H4) des Scheinwerfers (101, 501) umfasst, die Abblendlicht-Grenze (107, 503) eine erste parallele Linie, eine schräge Linie und eine zweite parallele Linie, mit der jeweils zwei Enden der schrägen Linie verbunden sind, einschließt. Die mehreren ersten Lichtemissionseinheiten (106, 507, 702, 903) sind entlang der ersten parallelen Linie und der zweiten parallelen Linie entlang der ersten parallelen Linie, der schrägen Linie und der zweiten parallelen Linie sowie einem Abstand zwischen diesen angeordnet den ersten lichtemittierenden Einheiten (106, 507, 702, 903) und eine vordere Brennebene (SF) der Linse (103, 401, 509, 801) kleiner ist als ein Abstand zwischen einer der zweiten lichtemittierenden Einheiten ( 108, 508, 703, 904, 1005) und die vordere Brennebene (SF) des Objektivs (103, 401, 509, 801).

2. Ein Scheinwerfer nach Anspruch 1, wobei eine Größe jeder der mehreren ersten lichtemittierenden Einheiten (702) kleiner als eine Größe jeder der mehreren zweiten lichtemittierenden Einheiten (703) ist.

3. Ein Scheinwerfer (501) nach Anspruch 1, wobei die lichtemittierende Vorrichtung (502) weiterhin ein Substrat (510) umfasst, eine erste Ebene (Sa) und eine zweite Ebene (Sb) auf einer Seite des Substrats liegen ( 510) nahe der Linse (509), die mehreren ersten lichtemittierenden Einheiten (507) sind auf der ersten Ebene (Sa) aufgeteilt; die mehreren zweiten lichtemittierenden Einheiten (508) sind auf der zweiten Ebene (Sb) angeordnet und ein Abstand von der ersten Ebene (Sa) zur vorderen Brennebene (SF) ist geringer als ein Abstand von der zweiten Ebene (Sb).) zur vorderen Brennebene (SF).

4. Ein Scheinwerfer (501) nach Anspruch 3, wobei die erste Ebene (Sa) und die vordere Brennebene (SF) überlappen.

5. Ein Scheinwerfer (501) nach Anspruch 3 oder 4, wobei die zweite Ebene (Sb) zwischen der ersten Ebene (Sa) und der Linse (509) liegt oder die erste Ebene (Sa) zwischen der zweiten Ebene (Sb) und der Linse (801) sich befindet.

6. Ein Scheinwerfer (501) nach Anspruch 1, wobei einige oder alle der mehreren ersten lichtemittierenden Einheiten (507) und die mehreren zweiten lichtemittierenden Einheiten (508) eine lichtemittierende Oberfläche aufweisen, die von einer Streuschicht bedeckt ist.

7. Ein Scheinwerfer (501) nach Anspruch 1, wobei die lichtemittierende Vorrichtung (502) außerdem ein Substrat (510) umfasst, wobei sich eine gekrümmte Oberfläche auf einer Seite des Substrats (510) nahe der Linse (509) befindet und die mehreren ersten lichtemittierenden Einheiten (507) und die mehreren zweiten lichtemittierenden Einheiten (508) auf der gekrümmten Oberfläche angeordnet sind.

8. Ein Scheinwerfer (101) nach Anspruch 1, wobei die lichtemittierende Vorrichtung (102) ferner einen lichtemittierenden Bereich umfasst, wobei die mehreren ersten lichtemittierenden Einheiten (106) und die mehreren zweiten lichtemittierenden Einheiten ( 108) im lichtemittierenden Bereich angeordnet sind, umfasst der lichtemittierende Bereich einen ersten Bereich (1) und einen zweiten Bereich (2) auf einer Seite der Abblendlicht-Grenze (107), wobei der zweite Bereich (2 ) an die Abblendlicht-Grenze (107) angrenzt, sind die mehreren ersten lichtemittierenden Einheiten (106) in einem Bereich des zweiten Bereichs (2) nahe der Abblendlicht-Grenze (107) vorgesehen, die mehreren zweiten lichtemittierenden Einheiten (108) im ersten Bereich (1) und anderen Bereichen des zweiten Bereichs (2) eingesetzt sind; und
der Scheinwerfer (101) weiterhin eine Steuerung (109) umfasst, die elektrisch mit den mehreren ersten lichtemittierenden Einheiten (106) und den mehreren zweiten lichtemittierenden Einheiten (108) verbunden ist, wobei die Steuerung (109) dazu konfiguriert ist, die mehrere ersten lichtemittierenden Einheiten (106) und die mehreren zweiten lichtemittierenden Einheiten (108), die Licht emittieren, zu steuern, um so eine Abblendlichtverteilung des Scheinwerfers zu realisieren.

9. Ein Scheinwerfer (501) nach Anspruch 8, wobei
der lichtemittierende Bereich umfasst außerdem einen dritten Bereich (3), der sich auf der anderen Seite der Abblendlicht-Grenzlinie (503) befindet;
die lichtemittierende Vorrichtung (502) umfasst ferner ein drittes lichtemittierendes Modul (504), das mehrere dritten lichtemittierenden Einheiten (505) umfasst, wobei die mehreren ersten lichtemittierenden Einheiten (507) in einem Bereich bereitgestellt sind; der dritte Bereich (3) liegt in der Nähe der Abblendlicht-Grenze (503) und die mehreren dritten lichtemittierenden Einheiten (505) sind in anderen Bereichen des dritten Bereichs (3) vorgesehen; und
die Steuerung (506) ist elektrisch mit den dritten lichtemittierenden Einheiten (505) verbunden und konfiguriert, um die ersten lichtemittierenden Einheiten (507), die zweiten lichtemittierenden Einheiten (508) zu steuern, und
die dritten Leuchteinheiten (505) Licht auszusenden, um so eine Fernlichtverteilung des Scheinwerfers (501) zu realisieren.

10. Ein Scheinwerfer (501) nach Anspruch 9, wobei ein Abstand von einem Teil der entsprechend dem ersten Bereich (1) vorgesehenen ersten lichtemittierenden Einheiten (507) zur vorderen Brennebene (SF) von einem Abstand und von einem anderen Teil der ersten lichtemittierenden Einheiten (507), die entsprechend dem dritten Bereich (3) vorgesehen sind, zur vorderen Brennebene (SF) unterschiedlich ist.

## Revendications

1. Un phare (101, 501), comprenant :
un dispositif d'émission de lumière (102, 502) comprenant :
une lentille (103, 401, 509, 801), un premier module émetteur de lumière (104) comprenant une pluralité de premières unités émettrices de lumière (106, 507, 702, 903) ; et
un deuxième module d'émission de lumière (105) comprenant une pluralité de deuxièmes unités d'émission de lumière (108, 508, 703, 904, 1005) ;
la lentille (103, 401, 509, 801) est configurée pour projeter la lumière des premières unités émettrices de lumière (106, 507, 702, 903) et des secondes unités émettrices de lumière (108, 508, 703, 904, 1005),
le premier module d'émission de lumière (104) est conçu pour projeter une distribution de lumière ayant une ligne de coupure de faisceau faible (H0-HV-H1-H4),
**caractérisé par le fait que** la pluralité de premières unités émettrices de lumière (106, 507, 702, 903) est disposée le long d'une ligne de coupure du faisceau de croisement (107, 503) correspondant à la ligne de coupure du faisceau de croisement (H0-HV-H1-H4) du phare(101, 501), la ligne de coupure du faisceau de croisement (107, 503) comprend une première ligne parallèle, une ligne oblique et une deuxième ligne parallèle, deux extrémités de la ligne oblique étant respectivement reliées à la première ligne parallèle et à la deuxième ligne parallèle, la pluralité de premières unités émettrices de lumière (106, 507, 702, 903) est disposée le long de la première ligne parallèle, de la ligne oblique et de la deuxième ligne parallèle, et une distance entre chacune des premières unités émettrices de lumière (106, 507, 702, 903) et un plan focal avant (SF) de la lentille (103, 401, 509, 801) est inférieure à une distance entre n'importe laquelle des deuxièmes unités émettrices de lumière (108, 508, 703, 904, 1005) et le plan focal avant (SF) de la lentille (103, 401, 509, 801).

2. Phare selon la revendication 1, dans lequel la taille de chacune des premières unités émettrices de lumière (702) est inférieure à la taille de chacune des deuxièmes unités émettrices de lumière (703).

3. Le phare (501) selon la revendication 1, dans lequel le dispositif émetteur de lumière (502) comprend en outre un substrat (510), un premier plan (Sa) et un second plan (Sb) sur un côté du substrat (510) proche de la lentille (509), la pluralité de premières unités émettrices de lumière (507) étant disposées sur le premier plan (Sa) ; la pluralité de secondes unités émettrices de lumière (508) sont disposées sur le second plan (Sb), et une distance entre le premier plan (Sa) et le plan focal avant (SF) est inférieure à une distance entre le second plan (Sb) et le plan focal avant (SF).

4. Phare (501) selon la revendication 3, dans lequel le premier plan (Sa) et le plan focal avant (SF) se chevauchent.

5. Phare (501) selon la revendication 3 ou 4, dans lequel le second plan (Sb) est situé entre le premier plan (Sa) et la lentille (509), ou le premier plan (Sa) est situé entre le second plan (Sb) et la lentille (801).

6. Phare (501) selon la revendication 1, dans lequel une partie ou la totalité de la pluralité de premières unités émettrices de lumière (507) et de la pluralité de secondes unités émettrices de lumière (508) ont une surface émettrice de lumière recouverte d'une couche de diffusion.

7. Le phare (501) selon la revendication 1, dans lequel le dispositif émetteur de lumière (502) comprend en outre un substrat (510), une surface incurvée se trouve sur un côté du substrat (510) près de la lentille (509), et la pluralité de premières unités émettrices de lumière (507) et la pluralité de secondes unités émettrices de lumière (508) sont disposées sur la surface incurvée.

8. Le phare (101) selon la revendication 1, dans lequel le dispositif émetteur de lumière (102) comprend en outre une zone d'émission de lumière, la pluralité de premières unités émettrices de lumière (106) et la pluralité de secondes unités émettrices de lumière (108) sont disposées dans la zone d'émission de lumière, la zone d'émission de lumière comprend une première zone (1) et une seconde zone (2) d'un côté de la ligne de coupure des feux de croisement (107), la deuxième zone (2) est adjacente à la ligne de coupure du faisceau de croisement (107), la pluralité de premières unités émettrices de lumière (106) est prévue dans une zone de la deuxième zone (2) proche de la ligne de coupure du faisceau de croisement (107), la pluralité de deuxièmes unités émettrices de lumière (108) est prévue dans la première zone (1) et dans d'autres zones de la deuxième zone (2) ; et
le phare (101) comprend en outre un contrôleur (109) connecté électriquement à la pluralité de premières unités émettrices de lumière (106) et à la pluralité de secondes unités émettrices de lumière (108), dans lequel le contrôleur (109) est configuré pour commander la pluralité de premières unités émettrices de lumière (106) et la pluralité de secondes unités émettrices de lumière (108) afin d'émettre de la lumière, de manière à réaliser une distribution de faisceau bas du phare.

9. Phare (501) selon la revendication 8, dans lequel
la zone de sortie de la lumière comprend en outre une troisième zone (3) située de l'autre côté de la ligne de coupure du faisceau de croisement (503) ;
le dispositif émetteur de lumière (502) comprend en outre un troisième module émetteur de lumière (504) comprenant une pluralité de troisièmes unités émettrices de lumière (505), dans lequel la pluralité de premières unités émettrices de lumière (507) est prévue dans une zone de la troisième zone (3) proche de la ligne de coupure du faisceau de croisement (503), et la pluralité de troisièmes unités émettrices de lumière (505) est prévue dans d'autres zones de la troisième zone (3) ; et
le contrôleur (506) est connecté électriquement aux troisièmes unités d'émission de lumière (505) et configuré pour contrôler les premières unités d'émission de lumière (507), les deuxièmes unités d'émission de lumière (508) et les troisièmes unités d'émission de lumière (508), et
les troisièmes unités émettrices de lumière (505) pour émettre de la lumière, de manière à réaliser une distribution de faisceau élevé du phare (501).

10. Phare (501) selon la revendication 9, dans lequel une distance entre une partie des premières unités émettrices de lumière (507) correspondant à la première zone (1) et le plan focal avant (SF) est différente d'une distance entre une autre partie des premières unités émettrices de lumière (507) correspondant à la troisième zone (3) et le plan focal avant (SF).
